# EUROPEAN PATENT APPLICATION

(11) **EP 1 199 838 A1**
(43) Date of publication of application: **24.04.2002**
(21) Application number: 00931620.9
(22) Date of filing: 31.05.2000
(51) Int. Cl.: H04L 7/08, H04Q 7/36

(54) **CLOCK**

(71) Applicant: MITSUBISHI DENKI KABUSHIKI KAISHA, Tokyo 100-8310 (JP)
(72) Inventor: ITOMITSU, Fujio, Mitsubishi Denki Kabushiki Kaisha, Chiyoda-ku, Tokyo 100-8310 (JP)
(74) Representative: Popp, Eugen, Dr.
(86) International application number: JP0003503
(87) International publication number: WO0193492

(57) **Abstract**

When the current system frame number RSFN is received from a base transceiver station controller 3, the system frame number RSFN and a system frame number SFN from a reference clock generating part 11 are compared to detect the phase difference between the both system frame numbers, and when the phase difference exceeds a prescribed value, the voltage to be applied to a voltage-controlled oscillator 19 is changed for a predetermined time to finely change the frequency of a source clock of the reference clock generating part 11, thereby gradually compensating for the phase difference.

## Description

### TECHNICAL FIELD

The present invention relates to a clock supply unit that is used to cancel phase shifts between plural base transceiver stations.

### BACKGROUND ART

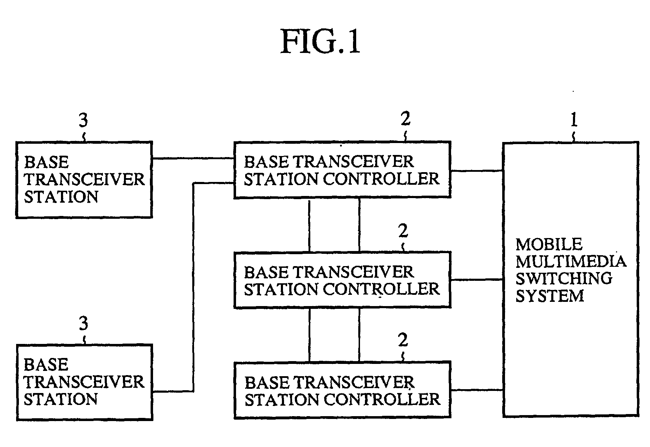

Fig. 1 is a block diagram depicting a conventional mobile communication system, in which reference numeral 1 denotes a mobile multimedia switching system, 2 base transceiver station controllers, and 3 base transceiver stations each having a built-in clock supply unit.

Next, the operation of the conventional system will be described below.

The base transceiver station controllers 2 each have control of tens of base transceiver stations 3, and need to keep system frame numbers of the base transceiver stations 3 in phase with one another during system operation.

To this end, on system startup each base transceiver station controller 2 outputs a system frame number RSFN to the plural base transceiver stations 3 simultaneously to initialize them. As a result of this, the system frame numbers of the plural base transceiver stations 3 are in phase with each other immediately after system startup.

Every base transceiver station 3 operates in synchronization with a reference clock from the corresponding base transceiver station controller 2, but the system frame number is phase shifted with the lapse of time due to jitter or wander of the reference clock, circuit malfunction, or the like.

Conventionally, each base transceiver station controller 2 monitors the plural base transceiver stations for phase shifts and, on detecting phase shifts between some of the plural base transceiver stations 3, provides the system frame number RSFN again to all the base transceiver stations 3 to make forced phase adjustments thereto, thereby instantaneously correcting the phase shifts.

With the conventional mobile communication system of the above configuration, upon detecting phase shifts between some of the plural base transceiver stations 3, the base transceiver station controller 2 provides the system frame number RSFN to every base transceiver station 3 to correct the phase shifts; however, since the system frame number RSFN is provided to all the base transceiver stations 3 to make forced phase adjustments thereto for instantaneous cancellation of the phase shifts, the base transceiver stations 3 adjusted in phase have difficulty in continuing radio communications, incurring the possibility of a short break occurring in radio communications.

The present invention is intended to solve such a problem as mentioned above and has for its object to provide a clock supply unit capable of canceling phase shifts between plural base transceiver stations without causing a short break in their radio communications.

### DISCLOSURE OF THE INVENTION

The clock supply unit according to the present invention detects a phase difference between an external reference system frame number and a system frame number and, when the phase difference is outside a predetermined range, change and outputs a source clock to clock generating means to compensate for the phase difference.

This produces the effect of canceling phase shifts between plural base transceiver stations without causing a short break in their radio communications.

The clock supply unit according to the present invention is adapted to decrease the voltage to be applied to the clock generating means when the system frame number provided from the clock generating means is ahead of the reference system frame number.

This has the effect of making the plural base transceiver stations in phase with each other.

The clock supply unit according to the present invention is adapted to increase the voltage to be applied to the clock generating means when the reference system frame number is ahead of the system frame number provided from the clock generating means.

This has the effect of making the plural base transceiver stations in phase with each other.

The clock supply unit according to the present invention is adapted to set the amount of change in the voltage to be applied to the clock generating means in accordance with a time of day.

This has the effect of achieving phase adjustments in accordance with the traveling speed of a mobile terminal.

The clock supply unit according to the present invention is adapted to set a larger amount of change in the voltage in the middle of the night than in the daytime.

This has the effect of reducing the time for phase adjustment when the traveling speed of the mobile terminal is low.

### BRIEF DESCRIPTION OF THE DRAWINGS

Fig. 1 is a block diagram showing a conventional mobile communication system.
Fig. 2 is a block diagram illustrating a clock supply unit according to Embodiment 1 of the present invention.
Fig. 3 is a block diagram illustrating a clock supply unit according to Embodiment 2 of the present invention.

### BEST MODE FOR CARRYING OUT THE INVENTION

To describe the present invention in more detail, the best mode for carrying out the present invention will be described with reference to the accompanying drawings.

### EMBODIMENT 1

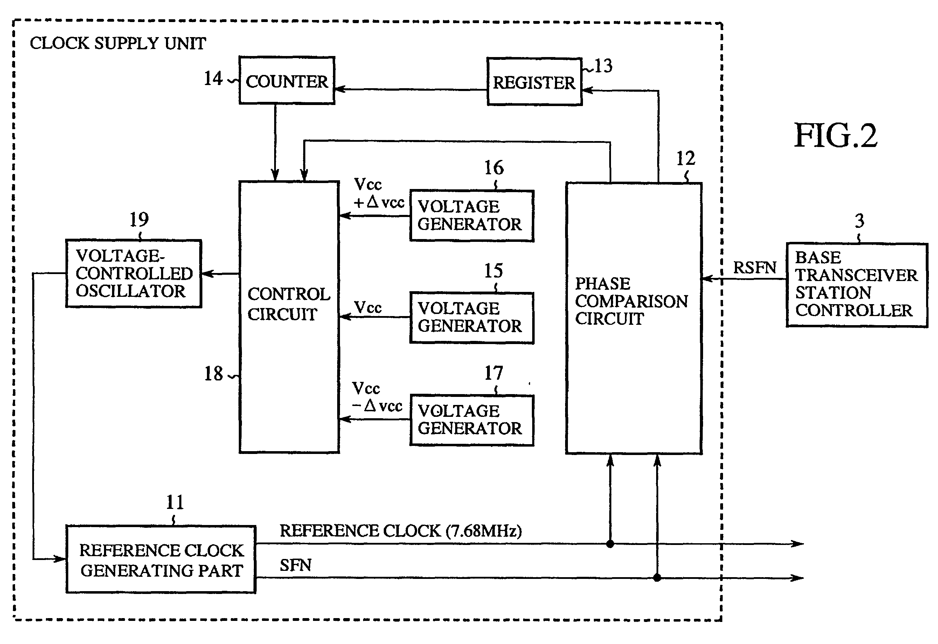

Fig. 2 is a block diagram illustrating a clock supply device according to Embodiment 1 of the present invention. In Fig. 2, reference numeral 11 denotes a reference clock generating part (clock generating means) which generates and outputs a reference clock and, at the same time, outputs the current system frame number SFN; 12 denotes a phase comparison circuit which, upon receiving the current system frame number RSFN, compares the system frame number RSFN with the system frame number SFN from the reference clock generating part 11 to detect a phase difference between the system frame numbers; 13 denotes a register for storing the phase difference detected by the phase comparison circuit 12; and 14 denotes a counter whose count value is set in correspondence with the phase difference stored in the register 13 and is decremented until it becomes zero. Incidentally, the phase comparison circuit 12, the register 13 and the counter 14 constitute phase difference detecting means.

Reference numeral 15 denotes a voltage generator for generating a voltage VCC; 16 denotes a voltage generator for generating a voltage VCC+ΔVCC; 17 denotes a voltage generator for generating a voltage VCC-ΔVCC; 18 denotes a control circuit which selects one of the voltage generators 15 to 17, and outputs the voltage from the selected voltage generator to a voltage-controlled oscillator 19; and 19 denotes the voltage-controlled oscillator which supplies the reference clock generating part 11 with a source clock of an oscillation frequency corresponding to the voltage fed from the control circuit 18. Incidentally, the voltage generators 15 to 17, the control circuit 18 and the voltage-controlled oscillator 19 constitute compensating means.

Next, the operation of this embodiment will be described below.

In the first place, the reference clock generating part 11 generates a reference clock corresponding to the source clock fed from the voltage-controlled oscillator 19, and outputs the current system frame number SFN.

That is, when supplied with a voltage higher than the voltage VCC for normal operation, the voltage-controlled oscillator 19 increases the frequency of the reference clock higher than a frequency (7.68 MHz) for normal operation to advance its phase. On the other hand, when supplied with a voltage lower than the voltage VCC for normal operation, the voltage-controlled oscillator decreases the frequency of the reference clock lower than the frequency (7.68 MHz) for normal operation to delay its phase.

Upon receiving the current system frame number RSFN from the base transceiver station controller 3, the phase comparison circuit 12 compares the system frame number RSFN with the system frame number SFN fed from the reference clock generating part 11 to detect the phase difference between them, and stores the phase difference in the register 13.

Incidentally, the system frame numbers RSFN and SFN each have 125-µs resolution, and if the phase difference between them is more than 125 µs, a phase shift is detected.

When the phase difference stored in the register 13 becomes larger than a prescribed value, the counter 14 is set to a value corresponding to the phase difference, and thereafter the count value is decremented in synchronization with the reference clock until it becomes zero. The counter 14 is made up of a counter whose count value goes to "1" when the phase difference is 10 ms and a counter whose count value goes to "1" when the phase difference is 125 µs. In this instance, when the phase difference is less than 125 µs, no phase adjustment is made.

The control circuit 18 selects one of the voltage generators 15 to 17, and provides the voltage from the selected voltage generator to the voltage-controlled oscillator 19.

That is, when the count value of the counter 14 is zero (i.e. when there is no phase shift), the control circuit selects the voltage generator 15 and provides the voltage VCC from the voltage generator 15 to the voltage-controlled oscillator 19.

When the system frame number SFN provided from the reference clock generating part 11 is ahead of the system frame number RSFN from the base transceiver station controller 3 (when the phase of the reference clock generating part 11 leads the phase of the base transceiver station controller), the control circuit selects the voltage generator 17 and provides the voltage VCC-ΔVCC from the voltage generator 17 to the voltage-controlled oscillator 19.

When the system frame number provided from the base transceiver station controller 3 is ahead of the system frame number from the reference clock generating part 11 (when the phase of the reference clock generating part 11 lags behind the phase of the base transceiver station), the control circuit selects the voltage generator 16 and provides the voltage VCC+ΔVCC from the voltage generator 16 to the voltage-controlled oscillator 19.

And the voltage-controlled oscillator 19 supplies the reference clock generating part 11 with a source clock corresponding to the voltage fed from the control circuit 18.

As is evident from the above, upon receiving the current system frame number RSFN from the base transceiver station controller 3, the clock supply unit according to Embodiment 1 compares the system frame number RSFN with the system frame number SFN provided from the reference clock generating part 11 to detect the phase difference between the system frame numbers and, if the phase difference exceeds a prescribed value, changes the applied voltage of the voltage-controlled oscillator 19 for a predetermined period to thereby gradually compensate for the phase difference on the part of the base transceiver station; hence, this embodiment has the effect of correcting phase shifts of plural base transceiver stations with no short break in radio communication.

### EMBODIMENT 2

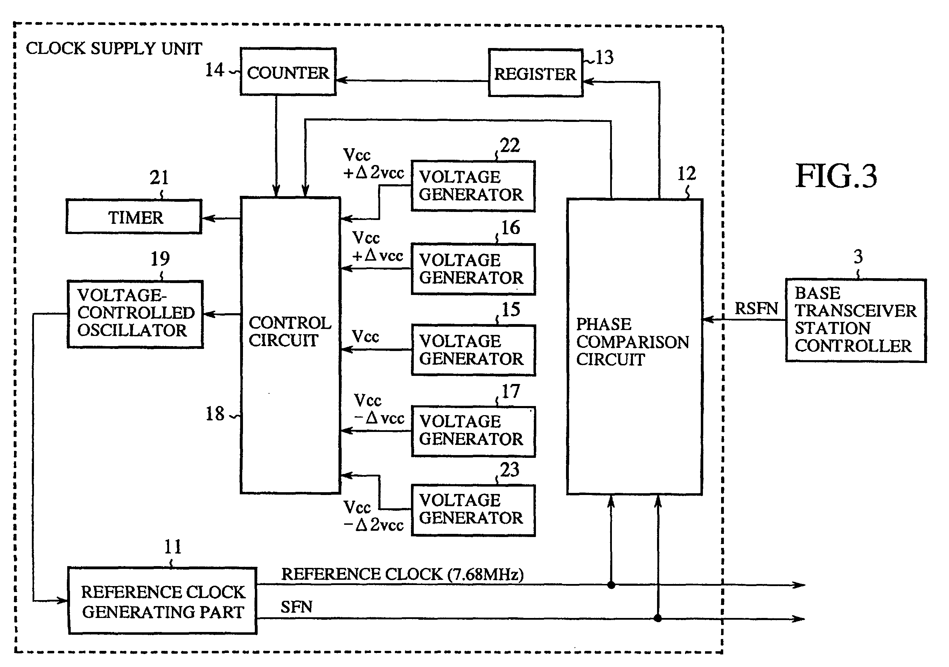

Fig. 3 is a block diagram illustrating a clock supply unit according to Embodiment 2 of the present invention. In Fig. 3 the same reference numerals as those in Fig. 2 designate identical or corresponding parts and no description will be repeated.

Reference numeral 21 denotes a timer which outputs the current time; 22 denotes a voltage generator for generating a voltage VCC+Δ2VCC; 23 denotes a voltage generator for generating a voltage VCC-Δ2VCC; and 24 denotes a control circuit which selects one of the voltage generators in accordance with the current time provided from the timer 21 and applies the voltage from the selected voltage generator to the voltage-controlled oscillator 19. Incidentally, the timer 21, the voltage generators 22 and 23 and the control circuit 24 constitute compensating means.

Next, the operation of this embodiment will be described below.

Embodiment 1 has been described to increase or decrease the applied voltage of the voltage-controlled oscillator 19 by ΔVCC for phase adjustment, and in this case the amount of change in the applied voltage needs to be increased to reduce the time for phase adjustment.

However, when the mobile terminal is loaded on a high-speed mobile unit like a shinkansen train, a phase variation is caused by a Doppler shift as the mobile terminal travels; accordingly, when the amount of change in the applied voltage is large, it is expected that no modulation/demodulation by a spreading code is impossible in some cases.

In view of the above, the amount of change in the applied voltage is set small in the daytime during which the mobile terminal is loaded on such a high-speed mobile unit as a shinkansen train, whereas in the middle of the night (for example, from midnight to five in the morning) during which the mobile terminal is rarely loaded on the shinkansen train or similar high-speed mobile unit the amount of change in the applied voltage is set large.

More specifically, reference is made to the current time provided from the timer 21, and if it is not late at night, the voltage generator 16 or 17 is selected to make the phase adjustment.

On the other hand, if it is late at night, the voltage generator 22 or 23 is selected to make the phase adjustment.

Thus, it is possible to reduce the time for phase adjustment in the middle of the night when it is unlikely to be affected by the phase variation resulting from the travel of the mobile terminal.

### INDUSTRIAL APPLICABILITY

As described above, the clock supply unit according to the present invention is suitable for use in a mobile communication system which carries out radio communications while canceling phase shifts of plural base transceiver stations.

## Claims

1. A clock supply unit comprising: clock generating means supplied with a source clock, for generating and outputting a reference clock while at the same time outputting a system frame number; phase difference detecting means supplied with an external reference system frame number, for detecting a phase difference between said reference system frame number and said system frame number; and compensating means for changing and outputting said source clock to said clock generating means to compensate for the phase difference when the phase difference detected by said phase difference detecting means is outside a predetermined range.

2. The clock supply unit according to claim 1, wherein the compensating means decreases the voltage to be applied to the clock generating means when the system frame number output from the clock generating means is ahead of the reference system frame number.

3. The clock supply unit according to claim 1, wherein the compensating means increases the voltage to be applied to the clock generating means when the reference system frame number is ahead of the system frame number output from the clock generating means.

4. The clock supply unit according to claim 1, wherein the compensating means sets the amount of change in the voltage to be applied to the clock generating means in accordance with a time of day.

5. The clock supply unit according to claim 4, wherein the compensating means sets a larger amount of change in the voltage in the middle of the night than in the daytime.
